# EUROPEAN PATENT APPLICATION

(11) **EP 4 180 156 A1**
(43) Date of publication of application: **17.05.2023**
(21) Application number: 20944665.7
(22) Date of filing: 09.07.2020
(51) Int. Cl.: B23B 27/14, B23C 5/16, B23B 51/00, C23C 16/27

(54) **DIAMOND COATED TOOL AND METHOD FOR PRODUCING SAME**

(71) Applicant: Sumitomo Electric Hardmetal Corp., Itami-shi, Hyogo 664-0016 (JP)
(72) Inventor: SUGIMOTO, Rintaro, Itami-shi, Hyogo 664-0016 (JP); HARADA, Takashi, Itami-shi, Hyogo 664-0016 (JP)
(74) Representative: Boult Wade Tennant LLP
(86) International application number: PCT/JP2020/026825
(87) International publication number: WO 2022/009375

(57) **Abstract**

The diamond-coated tool comprises a base material and a diamond layer disposed on the base material, wherein the skewness Ssk defined in ISO25178 of the diamond layer is more than 0.

## Description

### TECHNICAL FIELD

The present disclosure relates to a diamond-coated tool and a method for manufacturing the same.

### BACKGROUND ART

Diamond has a very high hardness, and the smooth surface thereof has an extremely low coefficient of friction. Therefore, a naturally occurring single crystal diamond and an artificial diamond powder have conventionally been applied to tool applications. Further, since a technique for forming a diamond thin film by a chemical vapor deposition (CVD) method was established in the 1980s, a cutting tool and a wear-resistant tool in which a diamond film is formed on a three-dimensionally shaped base material (hereinafter, these tools are also referred to as "diamond-coated tools") have been developed.

Japanese National Patent Publication No. 2001-501873 (Patent Literature 1) discloses a diamond-coated body wherein the surface of a base material made of a cemented carbide or a cermet is coated with a diamond layer.

### CITATION LIST

### PATENT LITERATURE

PTL 1: Japanese National Patent Publication No. 2001-501873

### SUMMARY OF INVENTION

The diamond-coated tool of the present disclosure is
a diamond-coated tool comprising a base material and a diamond layer disposed on the base material, wherein
a skewness Ssk defined in ISO25178 of the diamond layer is more than 0.

The method for manufacturing a diamond-coated tool according to the present disclosure is a method for manufacturing the above diamond-coated tool, comprising:
preparing a base material;
forming a diamond layer on the base material by a chemical vapor deposition method; and
subjecting the diamond layer to oxygen ion etching to obtain a diamond-coated tool.

### BRIEF DESCRIPTION OF DRAWINGS

Fig. 1 is a diagram illustrating a typical configuration example of the diamond-coated tool according to a first embodiment.
Fig. 2 is a diagram for illustrating a case where the skewness Ssk is more than 0.
Fig. 3 is a diagram for illustrating a case where the skewness Ssk is less than 0.
Fig. 4 is a diagram illustrating an example of a Raman spectrum of the diamond-coated tool according to the first embodiment.

### DETAILED DESCRIPTION

### [Problem to be Solved by the Present Disclosure]

In recent years, there has been a demand for a diamond-coated tool having excellent welding resistance and wear resistance and having a longer tool life, particularly in the cutting machining of an aluminum alloy, from the viewpoint of improving productivity.

### [Advantageous Effect of the Present Disclosure]

The diamond-coated tool of the present disclosure can have a long tool life, particularly even in the cutting machining of an aluminum alloy.

### [Description of Embodiments]

First, embodiments of the present disclosure will be listed and described.

(1) The diamond-coated tool of the present disclosure is a diamond-coated tool comprising a base material and a diamond layer disposed on the base material, wherein a skewness Ssk defined in ISO25178 of the diamond layer is more than 0.

The diamond-coated tool of the present disclosure can have a long tool life particularly even in the cutting machining of an aluminum alloy.

(2) The surface roughness Ra defined in JIS B 0601:2013 of the diamond layer is preferably 0.5 µm or less.

According to this, the welding resistance of the diamond-coated tool is improved, and the tool life is further extended. In addition, the surface quality of a work material is also improved.

(3) When a Raman spectrum having a Raman shift of 900 cm⁻¹ or more and 2000 cm⁻¹ or less of the diamond layer is measured, the ratio of the peak area intensity Id of diamond to the area intensity Is of the entire spectrum, Id/Is, is preferably 0.08 or more.

According to this, there are a large amount of sp3 carbon in the diamond layer and a small amount of sp2 carbon, which is likely to be welded to an aluminum alloy, and thus the welding resistance of the diamond-coated tool is improved and the tool life is further extended.

(4) The diamond layer has a maximum value of the oxygen content of preferably 20 atomic % or more in a region R surrounded by a main surface S on the surface side of the diamond-coated tool and a virtual surface Q that is located at a distance of 20 nm from the main surface S toward the side of the base material along a normal direction of the main surface S.

According to this, the oxidation resistance of the diamond layer is improved, the welding resistance and the wear resistance of the diamond-coated tool are improved, and the tool life is further extended.

(5) The method for manufacturing a diamond-coated tool according to the present disclosure is a method for manufacturing the above diamond-coated tool, comprising:
preparing a base material;
forming a diamond layer on the base material by a chemical vapor deposition method; and
subjecting the diamond layer to oxygen ion etching to obtain a diamond-coated tool.

According to this, it is possible to obtain a diamond-coated tool that can have a long tool life particularly even in the cutting machining of an aluminum alloy.

### [Details of Embodiments of the Present Disclosure]

With reference to the drawings, specific examples of the diamond-coated tool and the method for manufacturing the same according to the present disclosure will be described below. In the drawings of the present disclosure, the same reference numerals represent the same parts or equivalent parts. In addition, the dimensional relations of length, width, thickness, depth, and the like are appropriately changed for the purpose of clarifying and simplifying the drawings, and do not necessarily represent the actual dimensional relations.

As used herein, the notation in the form of "A to B" means the upper limit and the lower limit of the range (that is, A or more and B or less), and when there is no description of a unit in A and a unit is set forth only in B, the unit of A and the unit of B are the same.

### [First embodiment: Diamond-coated tool]

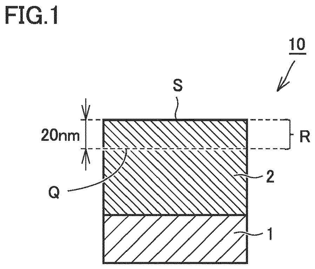

With reference to Fig. 1, the diamond-coated tool according to the first embodiment will be described. As shown in Fig. 1, a diamond-coated tool 10 includes a base material 1 and a diamond layer 2 disposed on base material 1, wherein the skewness Ssk defined in ISO25178 of diamond layer 2 is more than 0.

The diamond-coated tool of the present disclosure can have a long tool life particularly even in the cutting machining of an aluminum alloy. The reason for this is not clear, but it is presumed to be as follows.

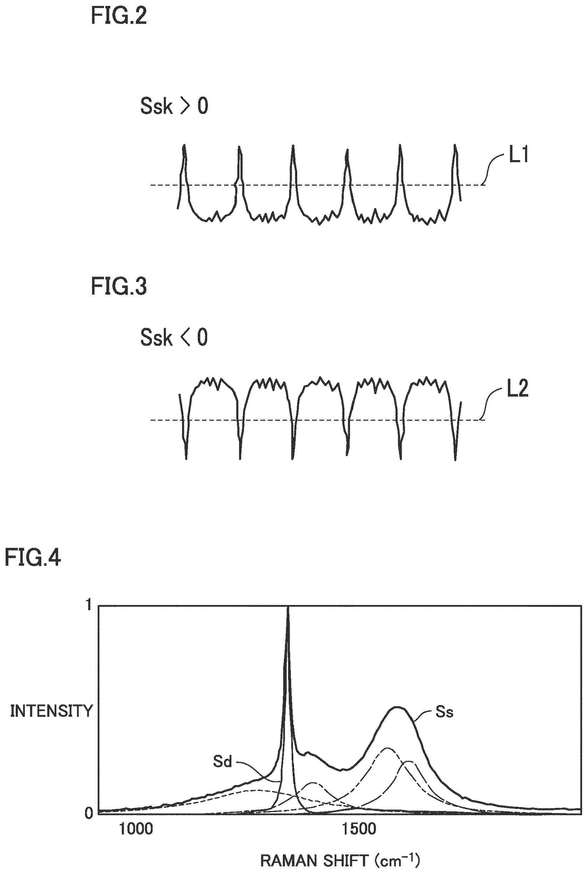

First, in order to facilitate the understanding of the present disclosure, the skewness (degree of bias) defined in ISO25178 (hereinafter, also referred to as "Ssk") will be described with reference to Fig. 2 and Fig. 3. Fig. 2 is a diagram for illustrating a case where the skewness Ssk of a surface is more than 0. Fig. 3 is a diagram for illustrating a case where the skewness Ssk of a surface is less than 0. Fig. 2 and Fig. 3 are each a cross-sectional view in a direction along the normal line to the surface.

The skewness Ssk is one of the three-dimensional surface texture parameters defined in ISO25178, and refers to the bias of the height distribution from a mean plane. As shown in Fig. 2, when the protrusions and depressions of the surface are biased downward with respect to a mean plane L1, Ssk is more than 0 (positive). As shown in Fig. 3, when the protrusions and depressions of the surface are biased upward with respect to a mean plane L2, Ssk is less than 0 (negative). When the protrusions and depressions of the surface are even with respect to a mean plane (not shown), Ssk is 0 (zero).

In the diamond-coated tool of the present disclosure, the skewness (Ssk) of diamond layer 2 is more than 0, and the protrusions and depressions of the surface of the diamond layer are biased downward as shown in Fig. 2. According to this, when a cutting oil is used during cutting machining, the cutting oil is likely to be retained in the depressed portions on the surface. Therefore, the diamond-coated tool is unlikely to undergo welding particularly even when an aluminum alloy is cut, has the wear of the cutting edge due to the welding, and can have a long tool life.

The diamond-coated tool can include any other configuration in addition to the base material and the diamond layer. The entire surface of the base material is preferably coated with the diamond layer, and at least the cutting edge portion of the base material is preferably coated therewith. Even if a part of the base material is not coated with the diamond layer, it does not deviate from the scope of the present embodiment.

### <Base material>

As the base material of the diamond-coated tool of the present disclosure, a base material containing a known hard particle can be used. Examples of such a base material include a cemented carbide (also including, for example, a WC-base cemented carbide, and one containing WC as well as Co or having a carbonitride or the like such as Ti, Ta, or Nb further added), a cermet (one containing TiC, TiN, TiCN, or the like as a main component), a high-speed steel, a tool steel, a ceramic (for example, titanium carbide, silicon carbide, silicon nitride, aluminum nitride, aluminum oxide, or a mixture thereof), a sintered cubic boron nitride material, and a sintered diamond material.

### <Diamond layer>

### (Skewness Ssk)

The skewness Ssk defined in ISO25178 of the diamond layer of the present disclosure is more than 0. According to this, when a cutting oil is used during cutting machining, the cutting oil is likely to be retained in the depressions on the surface. Therefore, the diamond-coated tool is unlikely to undergo welding particularly even when an aluminum alloy is cut, has the wear of the cutting edge due to the welding suppressed, and can have a long tool life.

The lower limit of Ssk of the diamond layer is more than 0, and preferably 0.05 or more or 0.1 or more. The upper limit of Ssk of the diamond layer is preferably 1.0 or less, 0.8 or less, or 0.6 or less. Ssk of the diamond layer is preferably more than 0 and 1.0 or less, 0.05 or more and 0.8 or less, or 0.1 or more and 0.6 or less.

Ssk of the diamond layer is determined by measuring the surface of the diamond layer using a laser microscope ("OPTELICS HYBRID" (trademark) manufactured by Lasertech Corporation) according to ISO25178-2:2012 and ISO25178-3:2012.

As the measurement field of view for Ssk of the diamond layer, 5 fields of view, each 200 µm square, are arbitrarily set within the range of 1 mm from the ridgeline of the tool cutting edge. Ssk is measured for each of the 5 measurement fields of view. The average value of Ssk in the 5 measurement fields of view is defined as Ssk of the diamond layer.

### (Surface roughness Ra)

The surface roughness Ra defined in JIS B 0601:2013 of the diamond layer of the present disclosure is preferably 0.5 µm or less. According to this, the welding resistance of the diamond-coated tool is improved, and the tool life is further extended. In addition, the surface quality of a work material is also improved.

The upper limit of the surface roughness Ra of the diamond layer is preferably 0.5 µm or less, 0.45 µm or less, or 0.4 µm or less. The lower limit of the surface roughness Ra of the diamond layer is preferably 0.01 µm or more, 0.05 µm or more, or 0.1 µm or more. The surface roughness Ra of the diamond layer is preferably 0.01 µm or more and 0.5 µm or less, 0.05 µm or more and 0.45 µm or less, or 0.1 µm or more and 0.4 µm or less.

The surface roughness Ra of the diamond layer means the arithmetical mean roughness Ra defined in JIS B 0601:2013. The surface roughness Ra of the diamond layer is determined by measuring the surface of the diamond layer using a laser microscope ("OPTELICS HYBRID" (trademark) manufactured by Lasertech Corporation) according to JIS B 0601:2013.

As the measurement field of view for the surface roughness Ra of the diamond layer, 5 fields of view, each 200 µm square, are arbitrarily set within the range of 1 mm from the ridgeline of the tool cutting edge. The surface roughness Ra is measured for each of the 5 measurement fields of view. The average value of the surface roughness Ra in the 5 measurement fields of view is defined as the surface roughness Ra of the diamond layer.

### (Raman spectrum)

When a Raman spectrum having a Raman shift of 900 cm⁻¹ or more and 2000 cm⁻¹ or less of the diamond layer of the present disclosure is measured, the ratio of the peak area intensity Id of diamond to the area intensity Is of the entire spectrum, Id/Is, is preferably 0.08 or more.

A larger ratio Id/Is indicates that there is more sp3 carbon in the diamond layer and less sp2 carbon that is likely to be welded to an aluminum alloy. In the diamond layer of the present disclosure, the ratio Id/Is is 0.08 or more, and thus the amount of sp2 carbon in the diamond layer is reduced, the welding resistance of the diamond-coated tool is improved, and the tool life is further extended.

The lower limit of the ratio Id/Is is preferably 0.08 or more, 0.085 or more, or 0.09 or more. The upper limit of the ratio Id/Is is preferably 0.5 or less, 0.4 or less, or 0.3 or less. The ratio Id/Is is preferably 0.08 or more and 0.5 or less, 0.085 or more and 0.4 or less, or 0.09 or more and 0.3 or less.

Herein, the above ratio Id/Is is calculated by the following procedure of (1-1) to (1-4).

(1-1) A measurement field of view of a rectangle of 200 µm × 200 µm (hereinafter, also referred to as a "measurement field of view for Raman spectroscopy") is set on the surface of the diamond layer on the surface of the tool. Five measurement fields of view for Raman spectroscopy are set.

(1-2) For each measurement field of view for Raman spectroscopy, a Raman spectrum in the range of a Raman shift of 900 cm⁻¹ to 2000 cm⁻¹ is obtained by a laser Raman measurement method according to JIS K 0137 (2010). At this time, the wavelength of light used as the incident light is in the ultraviolet region (325 nm). The Raman spectrometer used is "Ramantouch" (trademark) manufactured by Nanophoton Corporation. An example of a Raman spectrum of the diamond layer of the present disclosure is shown in Fig. 4. In Fig. 4, the spectrum shown by Sd shows a spectrum derived from diamond, and the spectrum shown by Ss shows the sum of all the spectra shown in Fig. 4.

(1-3) For the above Raman spectrum, the ratio Id/Is of the peak area intensity Id of diamond to the area intensity Is of the entire spectrum is calculated using image processing software ("Ramanimager" (trademark) manufactured by Nanophoton Corporation).

(1-4) The average value of the ratio Id/Is in the 5 measurement fields of view is calculated, and this average value is defined as the ratio Id/Is of the diamond layer.

### (Oxygen content)

The diamond layer of the first embodiment has a maximum value of the oxygen content of preferably 20 atomic % or more in a region R surrounded by a main surface S on the surface side of the diamond-coated tool and a virtual surface Q that is located at a distance of 20 nm from main surface S toward the side of the base material along a normal direction of main surface S.

According to this, the oxidation resistance of the diamond layer is improved, the welding resistance and the wear resistance of the diamond-coated tool are improved, and the tool life is further extended.

The lower limit of the maximum value of the oxygen content of region R of the diamond layer is preferably 20 atomic % or more, 25 atomic % or more, or 30 atomic % or more. The upper limit of the maximum value of the oxygen content is preferably 90 atomic % or less, 85 atomic % or less, or 80 atomic % or less. The maximum value of the oxygen content is preferably 20 atomic % or more and 90 atomic % or less, 25 atomic % or more and 85 atomic % or less, or 30 atomic % or more and 80 atomic % or less.

Herein, the oxygen content of region R of the diamond layer is measured while etching the surface of the diamond layer according to JIS K 0146:2002 (ISO14606:2000) using an Auger electron spectrometer ("PHI 4800" (trademark) manufactured by ULVAC-PHI, Inc.).

The measurement conditions are as follows.
(Electron beam parameters)
Electron energy: 10 kV, current value: 3 nA, incidence angle: 15°
(Ion beam (sputter parameters))
Ion species: argon, acceleration voltage: 1 kv, current value: 7 mA, raster region: 1.5 mm, time: 2 minutes
(Signal measurement)
Differentiation mode
(Others)

The elements measured are carbon, oxygen, and all other detected elements. The oxygen atom concentration is calculated based on all the elements to be analyzed.

The etching is carried out in the direction from the side of the surface of the diamond layer toward the side of the base material (hereinafter, also referred to as the "depth direction") along the normal direction of the surface thereof. The oxygen content is measured at points at intervals of 2 nm in the depth direction of the diamond layer, up to a point at a depth of 20 nm or more. This makes it possible to measure the oxygen content at intervals of 2 nm up to a point at 20 nm or more in the depth direction of the diamond layer.

### (Thickness)

The lower limit of the thickness of the diamond layer of the present disclosure can be 1 µm or more, 2 µm or more, or 3 µm or more. The upper limit of the thickness of the diamond layer of the present disclosure can be 40 µm or less, 35 µm or less, or 30 µm or less. The thickness of the diamond layer of the present disclosure can be 1 µm or more and 40 µm or less, 2 µm or more and 35 µm or less, or 3 µm or more and 30 µm or less.

Herein, the thickness of the diamond layer is measured by the following procedure. A diamond-coated tool is cut out using a wire electric discharge machine along the normal line to the surface of the diamond layer to expose a cross section. The thickness of the diamond layer is measured by observing the same in the cross section using an SEM (scanning electron microscope, "JEM-2100F/Cs" (trademark) manufactured by JEOL Ltd.). Specifically, the observation magnification of a cross-sectional sample is set to 5000 times, the observation field of view area is set to 100 µm², the thickness at three points is measured in the observation field of view, and the average value of the three points is defined as the thickness in the observation field of view. The measurement is carried out in 5 observation fields of view, and the average value of the thickness in the 5 observation fields is defined as the thickness of the diamond layer.

### (Use)

The diamond-coated tool according to the present embodiment can be usefully used as, for example, a cutting tool such as an indexable cutting insert, a bit, a cutter, a drill, or an end mill, and a wear-resistant tool such as a die, a bending die, a drawing die, or a bonding tool.

In the above, the first embodiment was described using an aluminum alloy as a work material, but the work material is not limited to the aluminum alloy. Examples of the work material include Carbon Fiber Reinforced Plastics (CFRP), titanium, a metal-base composite material, a ceramic, a ceramic-base composite material, and a cemented carbide.

### [Second embodiment: Method for manufacturing diamond-coated tool]

The method for manufacturing a diamond-coated tool according to a second embodiment can include a step of preparing a base material (hereinafter, also referred to as a "base material preparation step"), a step of forming a diamond layer on the base material by a chemical vapor deposition method (hereinafter, also referred to as a "diamond layer formation step"), and a step of subjecting the diamond layer to oxygen ion etching to obtain a diamond-coated tool (hereinafter, also referred to as a "oxygen ion etching step").

### (Base material preparation step)

As the base material, the base material according to the above embodiment is prepared. The base material is preferably subjected to a surface treatment such as a sandblasting treatment or an etching treatment. Thereby, an oxide film or a contaminant on the surface of the base material is removed. Further, the surface roughness of the base material is increased to thereby improve the close adhesion force between the base material and the diamond layer.

The sandblasting treatment can be carried out, for example, by projecting SiC having a grain diameter of 30 µm onto the base material at an injection pressure of 0.15 to 0.35 MPa.

For the etching treatment, for example, an acid solution treatment using 30% nitric acid or the like and an alkali treatment using sodium hydroxide or the like are carried out.

### (Diamond layer formation step)

Next, a seeding treatment is carried out by immersing the base material in, for example, a 0.1 g/L diamond seed crystal aqueous solution.

Next, a diamond layer is formed by a CVD method on the surface of the base material on which the diamond seed crystal is seeded. As the CVD method, a conventionally known CVD method can be used. Examples thereof that can be used include a microwave plasma CVD method, a plasma jet CVD method, and a hot filament CVD method.

For example, a diamond layer can be formed on a base material by disposing a substrate in a hot filament CVD apparatus, introducing methane gas and hydrogen gas into the apparatus at a mixing proportion of 0.5:99.5 to 10:90 on a volume basis, and keeping the substrate temperature at 700°C or more and 900°C or less.

### (Oxygen ion etching step)

Next, the diamond layer is subjected to oxygen ion etching to obtain a diamond-coated tool. Usually, the skewness of the diamond layer formed by CVD is 0 or less. In the present embodiment, the skewness Ssk of the surface of the diamond layer can be set to more than 0 by subjecting the diamond layer formed by CVD to oxygen ion etching.

In addition, by carrying out oxygen ion etching, the surface of the diamond layer is oxidized to improve the oxidation resistance of the diamond layer, and by selectively etching an sp2 component on the surface, the wear resistance and the welding resistance of the diamond-coated tool are improved.

The method of oxygen ion etching is not particularly limited, and a conventionally known method can be used.

The acceleration voltage during oxygen ion etching is preferably 3 kV or more and 6 kV or less. When the acceleration voltage is 3 kV or more, the skewness Ssk of the diamond layer is likely to be more than 0. When the acceleration voltage is 6 kV or less, the oxygen content of the diamond layer becomes appropriate, and the oxidation resistance of the diamond layer is likely to be improved.

The oxygen partial pressure during oxygen ion etching can be 0.001 Pa or more and 1000 Pa or less, 0.01 Pa or more and 500 Pa or less, or 0.05 Pa or more and 100 Pa or less.

The treatment time of oxygen ion etching can be 5 minutes or more and 600 minutes or less, 10 minutes or more and 450 minutes or less, or 15 minutes or more and 300 minutes or less.

Japanese National Patent Publication No. 2001-501873 (Patent Literature 1) discloses that the diamond layer is etched, but this is a treatment for smoothing the surface of the diamond layer. Therefore, the etching conditions described in Japanese National Patent Publication No. 2001-501873 (Patent Literature 1) are different from the oxygen ion etching conditions of the present disclosure, and the skewness Ssk of the diamond layer cannot be more than 0.

### <Supplementary note 1>

The skewness Ssk defined in ISO25178 of the diamond layer of the diamond-coated tool of the present disclosure is preferably more than 0 and 1 or less.

The skewness Ssk defined in ISO25178 of the diamond layer is preferably 0.05 or more and 0.8 or less.

The skewness Ssk defined in ISO25178 of the diamond layer is preferably 0.1 or more and 0.6 or less.

### <Supplementary note 2>

The surface roughness Ra defined in JIS B 0601:2013 of the diamond layer of the present disclosure is preferably 0.01 µm or more and 0.5 µm or less.

The surface roughness Ra defined in JIS B 0601:2013 of the diamond layer is preferably 0.05 µm or more and 0.45 µm or less.

The surface roughness Ra defined in JIS B 0601:2013 of the diamond layer is preferably 0.1 µm or more and 0.4 µm or less.

### <Supplementary note 3>

When a Raman spectrum having a Raman shift of 900 cm⁻¹ or more and 2000 cm⁻¹ or less of the diamond layer of the present disclosure is measured, the ratio of the peak area intensity Id of diamond to the area intensity Is of the entire spectrum, Id/Is, is preferably 0.08 or more and 0.5 or less.

The ratio Id/Is is preferably 0.085 or more and 0.4 or less.

The ratio Id/Is is preferably 0.09 or more and 0.3 or less.

### <Supplementary note 4>

The oxygen content of region R of the diamond layer of the present disclosure is preferably 20 atomic % or more and 90 atomic % or less.

The oxygen content is preferably 25 atomic % or more and 85 atomic % or less.

The oxygen content is preferably 30 atomic % or more and 80 atomic % or less.

### <Supplementary note 5>

The thickness of the diamond layer of the present disclosure is preferably 1 µm or more and 40 µm or less.

The thickness of the diamond layer of the present disclosure is preferably 2 µm or more and 35 µm or less.

The thickness of the diamond layer of the present disclosure is preferably 3 µm or more and 30 µm or less.

### <Supplementary note 6>

The method for manufacturing a diamond-coated tool according to the present disclosure includes:
preparing a base material;
forming a diamond layer on the base material by a chemical vapor deposition method; and
subjecting the diamond layer to oxygen ion etching to obtain a diamond-coated tool, wherein
in the oxygen ion etching, the acceleration voltage of an ion is preferably 3 kV or more and 6 kV or less.

### <Supplementary note 7>

The oxygen partial pressure during the oxygen ion etching is preferably 0.001 Pa or more and 1000 Pa or less.

The oxygen partial pressure during the oxygen ion etching is preferably 0.01 Pa or more and 500 Pa or less.

The oxygen partial pressure during the oxygen ion etching is preferably 0.05 Pa or more and 100 Pa or less.

### <Supplementary note 8>

The treatment time of the oxygen ion etching is preferably 5 minutes or more and 600 minutes or less.

The treatment time of the oxygen ion etching is preferably 10 minutes or more and 450 minutes or less.

The treatment time of the oxygen ion etching is preferably 15 minutes or more and 300 minutes or less.

The present embodiments will be described more specifically with reference to Examples. However, the present embodiments are not limited by these Examples.

### EXAMPLES

### [Sample 1 to sample 8]

### <Creation of diamond-coated tool>

### (Provision of base material)

As the base material, a cutting insert for an end mill, having a material of WC-6% Co (cemented carbide) and in the shape of tool model number AOET11T308PEFR-S was prepared.

### (Formation of diamond layer)

Subsequently, the surface of the base material was subjected to a seeding treatment using a diamond powder. The seeding treatment was carried out by immersing the base material in a solution obtained by mixing a diamond powder having an average particle diameter of 0.05 µm with water.

Next, the base material subjected to the above seeding treatment was set in a hot filament CVD apparatus to form a diamond layer. The film formation conditions are as follows.

The filament current was controlled such that the base material surface temperature was the temperature shown in the "Base material temperature (°C)" column of the "CVD Film formation conditions" in Table 1. The flow rates of methane and hydrogen were controlled such that the methane concentration was the concentration shown in the "Methane concentration (%)" column of the "CVD film formation conditions," and methane and hydrogen were supplied into a furnace. For all the samples, the pressure at the time of film formation was 500 mPa, and the film was formed until the film thickness of the diamond layer was 10 µm.

For example, in sample 1, the base material temperature at the time of film formation was 750°C, the methane concentration was 1%, and the pressure was 500 mPa.

### (Oxygen ion etching)

By subjecting the above diamond layer to oxygen ion etching, a diamond-coated tool of each sample was obtained. The conditions for oxygen ion etching are as follows.

The acceleration voltage during oxygen ion etching was as shown in the "Acceleration voltage (kV)" column of "Oxygen ion etching" in Table 1. The oxygen partial pressure was as shown in the "Oxygen partial pressure" column of "Oxygen ion etching" in Table 1. The oxygen ion etching time was 30 minutes for all samples.

For example, in sample 1, oxygen ion etching was carried out at an acceleration voltage of 3 kV and an oxygen partial pressure of 0.2 Pa for 30 minutes.

**[Table 1]**

| Table 1 | | | | | | | | | |
|---|---|---|---|---|---|---|---|---|---|
| Sample No. | CVD film formation conditions | | Oxygen ion etching | | Diamond layer | | | | Cutting test |
| | Methane concentration (%) | Base material temperature (°C) | Acceleration voltage (kV) | Oxygen partial pressure (Pa) | Ssk | Ra (µm) | Id/Is | Maximum value of oxygen content (atomic %) | Distance (m) |
| 1 | 1 | 750 | 3 | 0.2 | 0.48 | 0.36 | 0.085 | 29.6 | 62 |
| 2 | 3 | 800 | 4 | 0.15 | 0.27 | 0.14 | 0.114 | 48.8 | 70 |
| 3 | 2 | 800 | 5 | 0.2 | 0.36 | 0.47 | 0.132 | 53.6 | 58 |
| 4 | 3 | 780 | 6 | 0.1 | 0.13 | 0.26 | 0.098 | 69.2 | 51 |
| 5 | 2 | 800 | 0.5 | 0.1 | -0.12 | 0.49 | 0.071 | 11.2 | 25 |
| 6 | 1 | 750 | 1.5 | 0.2 | -0.26 | 0.31 | 0.064 | 13.4 | 18 |
| 7 | 8 | 800 | 2 | 0.15 | -0.31 | 0.39 | 0.075 | 15.2 | 23 |
| 8 | 9 | 780 | 1 | 0.2 | -0.16 | 0.61 | 0.055 | 18.4 | 12 |

### <Evaluations>

### (Skewness Ssk, surface roughness Ra, ratio Id/Is, and maximum value of oxygen content)

For the diamond layer of each sample, the skewness Ssk, the surface roughness Ra, the ratio Id/Is, and the maximum value of the oxygen content of region R were measured. The specific measurement methods are described in the first embodiment, and thus the description thereof will not be repeated. Results are shown in the "Ssk," "Ra," "Id/Is," and "maximum value of oxygen content (atomic %)" columns of the "Diamond layer" in Table 1.

### (Cutting test)

The diamond-coated tool (cutting insert) of each sample was attached to an end mill shank (made of steel, tool model number WEZ11032E02, tool diameter ϕ32, 2-flute), and a cutting test was carried out under the following conditions.
Work material: Die-cast aluminum (ADC12) block material of 300 mm × 150 mm × 50 mm
Cutting speed Vc: 1000 m/min
Feed speed Fz: 0.15 mm/t
Axial depth of cut, ap: 8 mm
Lateral depth of cut, ae: 3 mm
Cutting oil: Yes

In the above cutting test, the cutting distance until the maximum amount of flank wear reached 0.01 mm was measured. A longer cutting distance indicates a longer tool life. Results are shown in the "Distance" column of the "Cutting test" in Table 1.

### <Evaluations>

The diamond-coated tools of samples 1 to 4 correspond to Examples. The diamond-coated tools with coated surfaces of samples 5 to 8 correspond to Comparative Examples. It was confirmed that samples 1 to 4 (Examples) had a longer cutting distance and a longer tool life than samples 5 to 8 (Comparative Examples).

In samples 1 to 4, Ssk of the diamond layer is more than 0, and thus it is presumed that the cutting oil is likely to be retained in a depression on the surface during cutting, and welding is unlikely to occur, and thus the wear of the cutting edge due to the welding is suppressed and the tool life is long.

In samples 5 to 8, Ssk of the diamond layer is less than 0, and thus it is presumed that the cutting oil is less likely to be retained on the surface of the diamond layer during cutting, welding occurs, and the wear of the cutting edge is likely to proceed.

Although the embodiments and the Examples of the present disclosure have been described as described above, it is also intended from the beginning that the configurations of the above embodiments and Examples may be appropriately combined or variously altered.

It should be understood that the embodiments and the Examples disclosed this time are illustrative in all respects and non-limiting. The scope of the present invention is not shown by the embodiments and the Examples described above but by the claims, and is intended to include all modifications within the meaning and the scope equivalent to the claims.

### REFERENCE SIGNS LIST

1: base material, 2: diamond layer, 10: diamond-coated tool, S: main surface S, Q: virtual surface Q, R: region R

## Claims

1. A diamond-coated tool comprising a base material and a diamond layer disposed on the base material, wherein
a skewness Ssk defined in ISO25178 of the diamond layer is more than 0.

2. The diamond-coated tool according to claim 1, wherein a surface roughness Ra defined in JIS B 0601 :2013 of the diamond layer is 0.5 µm or less.

3. The diamond-coated tool according to claim 1 or claim 2, wherein when a Raman spectrum having a Raman shift of 900 cm⁻¹ or more and 2000 cm⁻¹ or less of the diamond layer is measured, a ratio of a peak area intensity Id of diamond to an area intensity Is of the entire spectrum, Id/Is, is 0.08 or more.

4. The diamond-coated tool according to any one of claim 1 to claim 3, wherein the diamond layer has a maximum value of an oxygen content of 20 atomic % or more in a region R surrounded by a main surface S on a surface side of the diamond-coated tool and a virtual surface Q that is located at a distance of 20 nm from the main surface S toward a side of the base material along a normal direction of the main surface S.

5. A method for manufacturing the diamond-coated tool according to any one of claim 1 to claim 4, comprising:
preparing a base material;
forming a diamond layer on the base material by a chemical vapor deposition method; and
subjecting the diamond layer to oxygen ion etching to obtain a diamond-coated tool.
